# EUROPEAN PATENT SPECIFICATION

(11) **EP 3 518 219 B1**
(45) Date of publication and mention of the grant of the patent: **30.06.2021**
(21) Application number: 17837932.7
(22) Date of filing: 31.08.2017
(51) Int. Cl.: G09F 9/30, G06F 1/16

(54) **DISPLAY APPARATUS**
ANZEIGEVORRICHTUNG
APPAREIL D'AFFICHAGE

(30) Priority: 26.09.2016 CN 201610849795
(43) Date of publication of application: 31.07.2019
(73) Proprietor: BOE Technology Group Co., Ltd., Beijing 100015 (CN)
(72) Inventor: SHI, Shiming, Beijing 100176 (CN)
(74) Representative: Gesthuysen Patentanwälte
(86) International application number: PCT/CN2017/099861
(87) International publication number: WO 2018/054203

(56) References cited:
- EP-A1- 2 403 222
- CN-A- 105 491 193
- CN-A- 105 812 509
- CN-A- 105 872 136
- CN-A- 106 157 819
- CN-U- 204 143 779
- US-A1- 2002 190 961
- US-A1- 2015 373 863
- US-A1- 2016 062 408
- US-A1- 2016 139 634

## Description

### FIELD OF THE DISCLOSURE

The present disclosure relates to the field of display technology, and in particular, to a flexible display device.

### BACKGROUND OF THE DISCLOSURE

Flexible display has become a hotspot technical trend in recent years, displays such as electronic paper, organic light-emitting diode(OLED), reflective LCD have the opportunity to realize flexible display screens. In particular, AMOLED (Active Matrix Organic Light Emitting Diode) is more conducive to the production of thinner, more flexible devices, with the advantages of active light emitting, good display effect, and high contrast. Therefore, it has the greatest potential for development in the future in the technical field of flexible display.

With the development of flexible display screens, people have higher and higher expectation on foldable display products. The bendable radius of flexible display screens such as flexible AMOLED is getting smaller and smaller, and now there is an opportunity to achieve foldable AMOLED display. As the bendable radius of the foldable display product becomes smaller and smaller, the difference between the inner radius and outer radius of the foldable display product during the folding and unfolding process gets larger and larger, which requires the foldable display product itself to have better stretch and contract performance, in order to effectively release the stress during the folding and unfolding process.

However, with the gradual decrease of the bendable radius of the foldable product, the stress cannot be completely released during the folding and unfolding process by relying only on the stretch and contract performance possessed by the foldable product itself. The unreleased stress generated during the folding and unfolding process will cause damages to the display product.

Therefore, it is necessary to provide an improved display device capable of effectively releasing stress.

US 2016/062408 A1, EP 2 403 222 A1 and US 2015/373863 relate to a flexible display with a mechanism for reducing the stress on the display during folding and unfolding.

### SUMMARY OF THE DISCLOSURE

In view of this, an embodiment of the present disclosure provides a display device according to claim 1. Further embodiments are described by dependent claims 2-7.

By providing the fold-assist mechanism, the display device can assist in folding and unfolding of the flexible display screen, and adjust the difference between the inner radius and the outer radius of the flexible display screen during folding and unfolding in order to effectively release stress of the flexible display screen during folding and unfolding, so that the flexible display is not easily damaged during folding and unfolding.

Beneficial effects of the present disclosure: by providing the fold-assist mechanism, the display device can assist the folding and unfolding of the flexible display screen, and adjust the difference between the inner radius and the outer radius of the flexible display screen during folding and unfolding to effectively release stress of the flexible display screen during folding and unfolding, so that the flexible display is not easily damaged during folding and unfolding.

### BRIEF DESCRIPTION OF THE DRAWINGS

Fig. 1 is a structural side view of a display device according to an embodiment of the present disclosure after being folded by 360°;
Fig. 2 is a structural side view of the display device according to the embodiment of the present disclosure after being unfolded by 180°;
Fig. 3 is a top plan view showing display region division of the flexible display screen of Fig. 2;
Fig. 4 is a schematic view of the display device according to the embodiment of the present disclosure being folded and unfolded in a range of 180-360°;
Figs. 5-7 are structural side views of some other variations of display devices according to embodiments of the present disclosure after being folded by 360°.

### DETAILED DESCRIPTION OF THE DISCLOSURE

In order to make those skilled in the art better understand the technical solutions of the present disclosure, the display device provided by the present disclosure is further described in detail below with reference to the accompanying drawings and specific implementations.

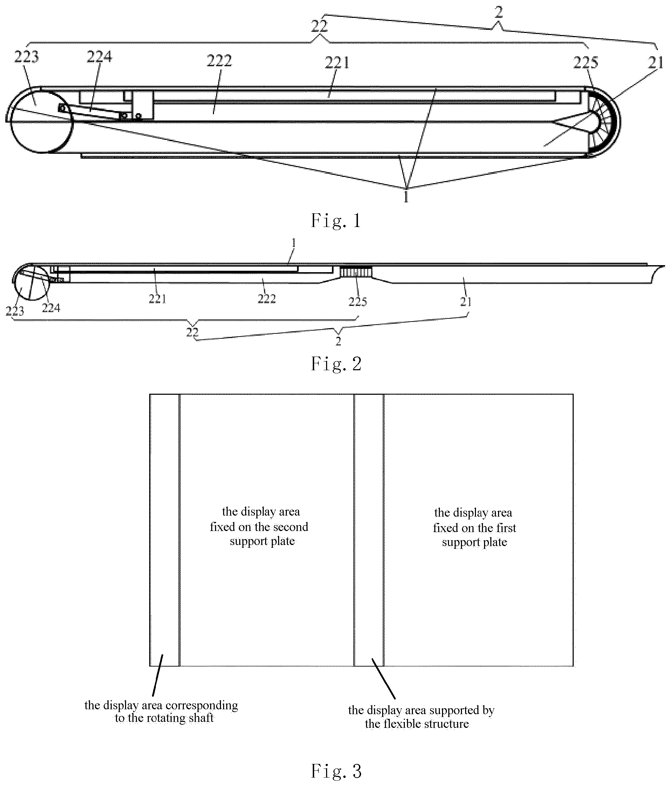

As shown in FIG. 1, FIG. 2 and FIG. 3, a display device provided by an embodiment of the present disclosure includes a flexible display screen 1, and further includes a fold-assist mechanism 2. The flexible display screen 1 is disposed on the fold-assist mechanism 2, the fold-assist mechanism 2 is configured to assist in folding and unfolding of the flexible display screen 1.

By providing the fold-assist mechanism 2, the display device can assist in folding and unfolding of the flexible display screen 1, and adjust the difference between the inner radius and the outer radius of the flexible display screen 1 during folding and unfolding to effectively release stress of the flexible display screen 1 during folding and unfolding, so that the flexible display screen is not easily damaged during folding and unfolding.

The fold-assist mechanism 2 includes a first support plate 21 and a fold-assist portion 22, the fold-assist portion 22 includes a second support plate 221 and a slide rail 222, the second support plate 221 is disposed on the slide rail 222, and can slide along the slide rail 222. A part of the flexible display screen 1 is fixed on the first support plate 21 and a part of the flexible display screen 1 is fixed on the second support plate 221 and a part of the flexible display screen 1 corresponding to the area between the first support plate 21 and the second support plate 221 can be folded or unfolded, the extension direction of the slide rail 222 is along the stretching and contracting direction of the flexible display screen 1 when folding and unfolding. In this way, when the fold-assist portion 22 assists in folding and unfolding of the flexible display screen 1, the second support plate 221 can slide along the slide rail 222 by the driving of the stretching force (that is, the middle region is stretched towards two sides opposite to each other) of the flexible display screen 1 when it is folded or the contracting force (that is, the two sides contract towards the middle region respectively) of the flexible display screen 1 when it is unfolded, thereby adjusting the difference between the inner radius and the outer radius of the flexible display screen 1 during folding and unfolding. In this way, when the flexible display screen 1 is folded or unfolded, the stress generated when it is stretched or the stress when it is contracted can be effectively released by the fold-assist portion 22, so that the flexible display screen 1 is not easily damaged by the stretch stress or the contraction stress during the folding and unfolding processes. The direction of the stretching force of the flexible display screen 1 during folding and the direction of the contracting force during unfolding are parallel to the plate surface of the second support plate 221. The extension direction of the slide rail 222 is along the stretching direction and contracting direction so that the stretch stress and the contract stress subjected by the flexible display screen 1 can be effectively released, thereby avoiding damages to the flexible display screen 1 caused by stretching or contracting.

The fold-assist portion 22 further includes a rotational structure disposed at a side of the second support plate 221 away from the first support plate 1, the rotational structure includes a rotating shaft 223 and a connecting rod 224, wherein the rotating shaft 223 is connected to the connecting rod 224, the connecting rod 224 is connected to the second support plate 221, and the rotating shaft 223 can be driven to rotate by the second support plate 221; a side edge of the flexible display screen 1 corresponding to the rotational structure is fixed on the rotating shaft 223. The rotating shaft 223 is provided to assist in releasing a part of the flexible display screen 1 at its edge from the rotating shaft 223 or winding this part of the flexible display screen 1 onto the outer peripheral surface of the rotating shaft 223 when the flexible display screen 1 is folded or unfolded, so that the stretch stress or the contract stress subjected by the flexible display screen 1 during the folding and unfolding processes can be released. In this way, the flexible display screen 1 is not easily damaged by stretch stress or contract stress during folding or unfolding process.

A side edge region of the flexible display screen 1 corresponding to the rotational structure is outspreadly disposed on an outer peripheral surface of the rotating shaft 223. That is, regardless of whether the flexible display screen 1 is in the folded state or the unfolded state, a portion of one side edge region corresponding to the rotational structure can be outspreadly disposed on the outer peripheral surface of the rotating shaft 223. With this curved portion of the flexible display screen 1 outspreadly disposed on the outer peripheral surface of the rotating shaft 223, the flexible display screen 1 can display some image or information with specific functions such as date and time information, weather information or some other reminder information and so on; thus, the display content and the display form of the display device can be more diversified.

According to an aspect of the present disclosure, an axial direction of the rotating shaft 223 is perpendicular to the extension direction of the slide rail 222. In this way, one side edge of the flexible display screen 1 can be completely wound on the rotating shaft 223 so that the stretch stress or the contract stress subjected by the entire face of the flexible display panel 1 when folding or unfolding can be completely released. In this way, local stress when the flexible display 1 is folded and unfolded can be avoided to become excessive, thereby protecting the flexible display 1 from partial damage.

The first support plate 21 and the second support plate 221 are spaced apart from each other. A portion of the flexible display screen 1 corresponding to the spacing region between the first support plate 21 and the second support plate 221 can be folded or unfolded. The spacing region is provided to increase the distance between the first support plate 21 and the second support plate 221 so as to prevent the portion of the flexible display screen 1 corresponding to the area between the first support plate 21 and the second support plate 221 from being rubbed by the opposite edges of the first support plate 21 and the second support plate 221 during folding or unfolding, thereby to avoid damage to the corresponding area of the flexible display screen 1 by the opposite edges of the first support plate 21 and the second support plate 221.

According to an aspect of the present disclosure, the fold-assist portion 22 further comprises a flexible structure 225 provided in the spacing region between the first support plate 21 and the second support plate 221, and connected to the first support plate 21 and the second support plate 221 respectively; and the flexible structure 225 can be folded or unfolded for supporting the portion of the flexible display screen 1 corresponding to the spacing region. The flexible structure 225 is provided to support the flexible curved portion of the flexible display screen 1 when the flexible display screen 1 is folded and unfolded, so as to prevent the flexible curved portion from being damaged due to frequent arbitrary folding and unfolding.

The flexible structure 225 comprises a flexible plate, the flexible plate is made of elastic rubber or elastic plastic material. The flexible plate has a certain degree of flexibility which not only can support the flexible curved portion of the flexible display screen 1 but also can be folded or unfolded along with the flexible curved portion so as to reinforce the flexible curved portion and prevent the flexible curved portion from being damaged during folding or unfolding.

It should be noted that the flexible structure 225 may also be a bendable hinge or a metal rotary shaft. The bendable hinge can be arbitrarily bent along with the flexible curved portion of the display panel. The metal rotary shaft can be rotated about its axis by 360° to assist in arbitrarily folding or unfolding with the flexible curved portion of the display screen. At the same time, a side of the bendable hinge and the metal rotary shaft can also support the flexible curved portion of the flexible display screen 1.

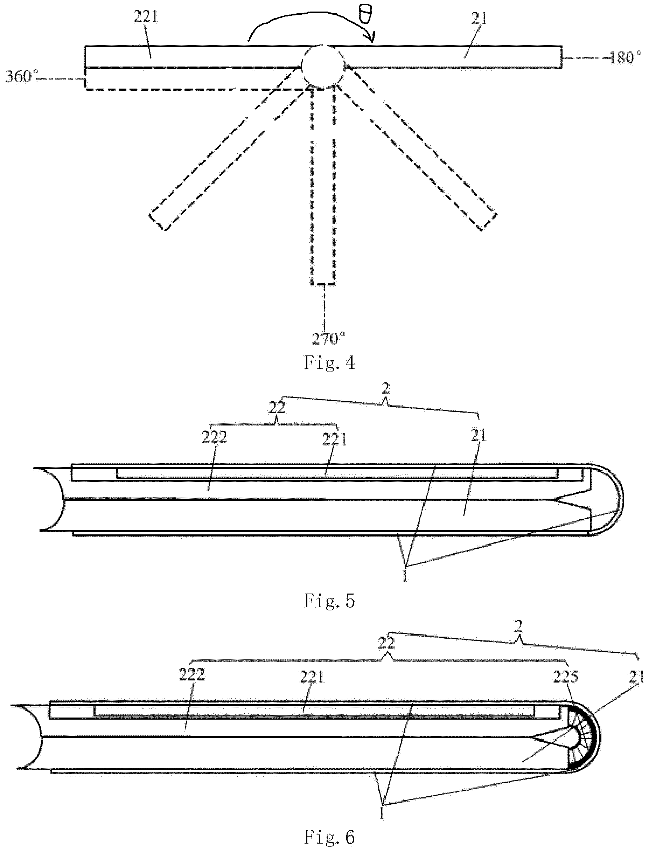

As shown in FIG. 4, the fold-assist portion 22 can assist the portion of the flexible display screen 1 correspondingly fixed on the second support plate 221 and the portion of the flexible display screen 1 correspondingly fixed on the first support plate 21 to form an angle θ varying from 180° to 360°.

The display device may further include a position sensor (not shown) and a control element (not shown), wherein the position sensor and the control element are electrically connected; the position sensor is provided on the rotating shaft 223 for obtaining the rotation angle of the rotating shaft 223; the control element can obtain the folding or unfolding angle of the flexible display screen 1 based on the rotation angle of the rotating shaft 223, and control the flexible display screen 1 to adopt different display modes based on the folding or unfolding angle of the flexible display screen 1. In this way, the display device can display in different modes based on its folded or unfolded situation. Thus, the display device can display in various modes according to the folding condition thereof, so as to make the display content and the display form of the display device more diversified.

According to an aspect of the present disclosure, when the folding or unfolding angle of the flexible display screen is 180°, the flexible display screen adopts a flat panel display mode. When the folding or unfolding angle of the flexible display screen changes within the range of 180° - 225°, the flexible display screen adopts a page turning display mode. When the folding or unfolding angle of the flexible display screen is 270°, the flexible display screen adopts a left and right screen copy display mode. When the folding or unfolding angle of the flexible display screen changes within the range of 270° - 360°, the flexible display screen adopts a power saving display mode with the left screen or the right screen turned off.

For example, when the unfolding angle of the flexible display screen 1 is at an angle of 180°, it has flat panel display function, and the screen is displayed in full screen. When the unfolding angle of the flexible display screen 1 varies back and forth within the range of 180° to 225°, the screen is displayed in full screen, and it has page turning function or can switch to different display interface. When the unfolding angle of the flexible display screen 1 is at an angle of 270°, the left and right screens are copied and displayed, so that two people can use and view information face to face. When the unfolding angle of the flexible display screen 1 is within the range of 270° to 360°, the display area supported by the first support plate 21 or the display area supported by the second support plate 221 can be turned off to enter the power saving mode. When the unfolding angle of the flexible display screen 1 is 360°, the display area supported by the first support plate 21 or the display area supported by the second support plate 221 displays corresponding information based on the user's use.

As a variation of the display device shown in FIGS. 1-4, as shown in FIG. 5, the fold-assist portion 22 may only consist of the second support plate 221 and the slide rail 222.

The structure and function of the second support plate 221 and the slide rail 222 are the same as those shown in FIGS. 1-4. Other structures and functions of the fold-assist mechanism 2 and other structures of the display device are the same as those shown in FIGS. 1-4, which are not described herein again.

As another variation of the display device shown in FIGS. 1-4, as shown in FIG. 6, the fold-assist portion 22 may only consist of the second support plate 221, the slide rail 222 and the flexible structure 225.

The structures and functions of the second support plate 221, the slide rail 222 and the flexible structure 225 are the same as those shown in FIGS. 1-4. Other structures and functions of the fold-assist mechanism 2 and other structures of the display device are the same as those shown in FIGS. 1-4, which are not described herein again.

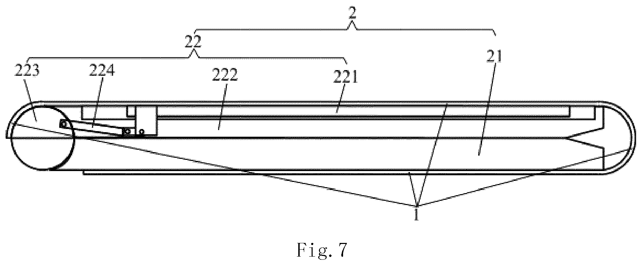

As a further variation of the display device shown in FIGS. 1-4, as shown in FIG. 7, the fold-assist portion 22 may only consist of the second support plate 221, the slide rail 222, the rotating shaft 223 and the connecting rod 224.

The structures and functions of the second support plate 221, the slide rail 222, the rotating shaft 223 and the connecting rod 224 are the same as those shown in FIGS. 1-4. Other structures and functions of the fold-assist mechanism 2 and other structures of the display device are the same as those shown in FIGS. 1-4, which are not described herein again. The display device according to the present disclosure has the following beneficial effects: by providing the fold-assist mechanism, the display device can assist in folding and unfolding of the flexible display screen, and adjust the difference between the inner radius and the outer radius of the flexible display screen during folding and unfolding to effectively release stress of the flexible display screen during folding and unfolding, so that the flexible display is not easily damaged during folding and unfolding.

The display device provided by the present disclosure may be any product or component having flexible display function, such as an OLED panel, an OLED television, a display, a cell phone, a navigator, and the like.

## Claims

1. A display device comprising a flexible display screen (1) and a fold-assist mechanism (2), wherein the flexible display screen is disposed on the fold-assist mechanism, the fold-assist mechanism is configured to assist in folding and unfolding of the flexible display screen,
wherein the fold-assist mechanism comprises a first support plate (21) and a fold-assist portion (22), the fold-assist portion comprises a second support plate (221) and a slide rail (222), the second support plate is disposed on the slide rail and can slide along the slide rail, a part of the flexible display screen is fixed on the first support plate and a part of the flexible display screen is fixed on the second support plate, the first support plate and the second support plate are spaced apart from each other, and a portion of the flexible display screen corresponding to a spacing region between the first support plate and the second support plate can be folded or unfolded, and an extension direction of the slide rail is in a stretching and contracting direction of the flexible display screen when folding and unfolding,
wherein the fold-assist portion further comprises a flexible structure (225) provided in the spacing region between the first support plate and the second support plate, and connected to the first support plate and the second support plate respectively, the flexible structure is configured to be folded or unfolded and comprise a flexible plate made of elastic rubber or elastic plastic material for supporting the portion of the flexible display screen corresponding to the spacing region, and
wherein the fold-assist portion further comprises a rotational structure disposed at a side of the second support plate away from the first support plate, the rotational structure comprises a rotating shaft (223) and a connecting rod (224), the connecting rod is configured to connect the rotating shaft and the second support plate with each other so that the second support plate can push the connecting rod to move, and the movement of the connecting rod then pushes the rotating shaft to rotate, and wherein a side edge of the flexible display screen corresponding to the rotational structure is fixed on the rotating shaft, one end of the connecting rod is connected to the second support plate, and the other end of the connecting rod is movably connected to the rotating shaft and can rotate together with the rotating shaft.

2. The display device according to claim 1, wherein a side edge region of the flexible display screen corresponding to the rotational structure is outspreadly disposed on an outer peripheral surface of the rotating shaft.

3. The display device according to claim 1, wherein an axial direction of the rotating shaft is perpendicular to the extension direction of the slide rail.

4. The display device according to claim 1, wherein the flexible structure further comprises a bendable hinge or a metal rotary shaft.

5. The display device according to any one of claim 1, wherein the fold-assist portion is configured to assist the part of the flexible display screen correspondingly fixed on the second support plate and the part of the flexible display screen correspondingly fixed on the first support plate to form an angle varying from 180° to 360°, whereby an angle of 360° corresponds to the state wherein the display device is folded, whereby an angle of 180° corresponds to the state wherein the display device is unfolded.

6. The display device according to claim 5, further comprising a position sensor and a control element, wherein the position sensor and the control element are electrically connected; the position sensor is provided on the rotating shaft and configured to obtain a rotation angle of the rotating shaft; the control element is configured to obtain a folding or unfolding angle of the flexible display screen based on the rotation angle of the rotating shaft, and control the flexible display screen to adopt different display modes based on the folding or unfolding angle of the flexible display screen.

7. The display device according to claim 6, wherein,
when the folding or unfolding angle of the flexible display screen is 180° the flexible display screen is configured to adopt a flat panel display mode; when the folding or unfolding angle of the flexible display screen changes within a range of 180° - 225°, the flexible display screen is configured to adopt a page turning display mode;
when the folding or unfolding angle of the flexible display screen is 270°, the flexible display screen is configured to adopt a left and right screen copy display mode;
when the folding or unfolding angle of the flexible display screen changes within the range of 270° - 360°, the flexible display screen is configured to adopt a power saving display mode with the left screen or the right screen turned off.

## Patentansprüche

1. Anzeigevorrichtung, umfassend einen flexiblen Anzeigebildschirm (1) und einen Faltunterstützungsmechanismus (2),
wobei der flexible Anzeigebildschirm auf dem Faltunterstützungsmechanismus angeordnet ist, wobei der Faltunterstützungsmechanismus dazu ausgelegt ist, das Falten und Entfalten des flexiblen Anzeigebildschirms zu unterstützen,
wobei der Faltunterstützungsmechanismus eine erste Trägerplatte (21) und einen Faltunterstützungsabschnitt (22) umfasst, wobei der Faltunterstützungsabschnitt eine zweite Trägerplatte (221) und eine Gleitschiene (222) umfasst,
die zweite Trägerplatte auf der Gleitschiene angeordnet ist und entlang der Gleitschiene gleiten kann, ein Teil des flexiblen Anzeigebildschirms an der ersten Trägerplatte befestigt ist und ein Teil des flexiblen Anzeigebildschirms an der zweiten Trägerplatte befestigt ist, die erste Trägerplatte und die zweite Trägerplatte voneinander beabstandet sind und ein Abschnitt des flexiblen Anzeigebildschirms, der einem Abstandsbereich zwischen der ersten Trägerplatte und der zweiten Trägerplatte entspricht, gefaltet oder entfaltet werden kann, und eine Ausdehnungsrichtung der Gleitschiene in einer Streck- und Zusammenziehrichtung des flexiblen Anzeigebildschirms beim Falten und Entfalten liegt,
wobei der Faltunterstützungsabschnitt ferner eine flexible Struktur (225) umfasst, die in dem Abstandsbereich zwischen der ersten Trägerplatte und der zweiten Trägerplatte vorgesehen und mit der ersten Trägerplatte bzw. der zweiten Trägerplatte verbunden ist, wobei die flexible Struktur dazu ausgelegt ist, gefaltet oder entfaltet werden zu können, und eine flexible Platte aus elastischem Gummi oder elastischem Kunststoffmaterial zu umfassen, um den Abschnitt des flexiblen Anzeigebildschirms entsprechen dem Abstandsbereich zu tragen, und
wobei der Faltunterstützungsabschnitt ferner eine Drehstruktur umfasst, die an einer von der ersten Trägerplatte abgewandten Seite der zweiten Trägerplatte angeordnet ist, wobei die Drehstruktur eine Drehwelle (223) und eine Verbindungsstange (224) umfasst,
die Verbindungsstange dazu ausgelegt ist, die Drehwelle und die zweite Trägerplatte miteinander zu verbinden, sodass die zweite Trägerplatte die Verbindungsstange drücken kann, um sich zu bewegen, und die Bewegung der Verbindungsstange dann die Drehwelle drückt, um sich zu drehen, und wobei eine Seitenkante des flexiblen Anzeigebildschirms, die der Drehstruktur entspricht, an der Drehwelle befestigt ist, ein Ende der Verbindungsstange mit der zweiten Trägerplatte verbunden ist und das andere Ende der Verbindungsstange bewegbar mit der Drehwelle verbunden ist und sich zusammen mit der Drehwelle drehen kann.

2. Anzeigevorrichtung gemäß Anspruch 1, wobei ein der Drehstruktur entsprechender Seitenkantenbereich des flexiblen Anzeigebildschirms auf einer Außenfläche der Drehwelle ausgebreitet angeordnet ist.

3. Anzeigevorrichtung gemäß Anspruch 1, wobei eine axiale Richtung der Drehwelle rechtwinklig zur Ausdehnungsrichtung der Gleitschiene verläuft.

4. Anzeigevorrichtung gemäß einem der Anspruch 1, wobei die flexible Struktur ferner ein biegbares Scharnier oder eine metallische Drehwelle umfasst.

5. Anzeigevorrichtung gemäß Anspruch 1, wobei der Faltunterstützungsabschnitt dazu ausgelegt ist, den Teil des flexiblen Anzeigebildschirms, der entsprechend an der zweiten Trägerplatte befestigt ist, und den Teil des flexiblen Anzeigebildschirms, der entsprechend an der ersten Trägerplatte befestigt ist, dabei unterstützt, einen von 180° bis 360° variierenden Winkel zu bilden, wobei ein Winkel von 360° dem Zustand entspricht, in dem die Anzeigevorrichtung gefaltet ist, wobei ein Winkel von 180° dem Zustand entspricht, in dem die Anzeigevorrichtung entfaltet ist.

6. Anzeigevorrichtung gemäß Anspruch 5, ferner umfassend einen Positionssensor und ein Steuerelement, wobei der Positionssensor und das Steuerelement elektrisch verbunden sind; der Positionssensor an der Drehwelle vorgesehen und dazu ausgelegt ist, einen Drehwinkel der Drehwelle zu ermitteln; das Steuerelement dazu ausgelegt ist, einen Falt- oder Entfaltwinkel des flexiblen Anzeigebildschirms basierend auf dem Drehwinkel der Drehwelle zu ermitteln und den flexiblen Anzeigebildschirm dazu zu steuern, verschiedene Anzeigemodi basierend auf dem Falt- oder Entfaltwinkels des flexiblen Anzeigebildschirms anzunehmen.

7. Anzeigevorrichtung gemäß Anspruch 6, wobei,
wenn der Falt- oder Entfaltwinkel des flexiblen Anzeigebildschirms 180° beträgt, der flexible Anzeigebildschirm dazu ausgelegt ist, einen Flachbildschirmanzeigemodus anzunehmen;
wenn sich der Falt- oder Entfaltwinkel des flexiblen Anzeigebildschirms innerhalb eines Bereichs von 180° - 225° ändert, der flexible Anzeigebildschirm dazu ausgelegt ist, einen Seitenumschlaganzeigemodus anzunehmen;
wenn der Falt- oder Entfaltwinkel des flexiblen Anzeiegbildschirms 270° beträgt, der flexible Anzeigebildschirm dazu ausgelegt ist, einen linken und rechten Bildschirmkopieanzeigemodus anzunehmen;
wenn sich der Falt- oder Entfaltwinkel des flexiblen Anzeigebildschirms im Bereich von 270° - 360° ändert, der flexible Anzeigebildschirm dazu ausgelegt ist, einen stromsparenden Anzeigemodus anzunehmen, bei dem der linke Bildschirm oder der rechte Bildschirm ausgeschaltet ist.

## Revendications

1. Dispositif d'affichage comprenant un écran d'affichage flexible (1) et un mécanisme d'aide au pliage (2),
dans lequel l'écran d'affichage flexible est disposé sur le mécanisme d'aide au pliage, le mécanisme d'aide au pliage est configuré pour faciliter le pliage et le dépliage de l'écran d'affichage flexible,
dans lequel le mécanisme d'aide au pliage comprend une première plaque de support (21) et une partie d'aide au pliage (22),
la partie d'aide au pliage comprend une deuxième plaque de support (221) et un rail glissière (222),
la deuxième plaque de support est disposée sur le rail glissière et peut glisser le long du rail glissière, une partie de l'écran d'affichage flexible est fixée sur la première plaque de support et une partie de l'écran d'affichage flexible est fixée sur la deuxième plaque de support, la première plaque de support et la deuxième plaque de support sont espacées l'une de l'autre, et une partie de l'écran d'affichage flexible correspondant à une région d'espacement entre la première plaque de support et la deuxième plaque de support peut être pliée ou dépliée, et une direction d'extension du rail glissière est dans une direction d'étirement et de contraction de l'écran d'affichage flexible lors du pliage et du dépliage,
dans lequel la partie d'aide au pliage comprend en outre une structure flexible (225) fournie dans la région d'espacement entre la première plaque de support et la deuxième plaque de support, et raccordée à la première plaque de support et à la deuxième plaque de support respectivement, la structure flexible est configurée pour être pliée ou dépliée et comprend une plaque flexible constituée de matériau caoutchouc élastique ou plastique élastique pour supporter la partie de l'écran d'affichage flexible correspondant à la région d'espacement, et
dans lequel la partie d'aide au pliage comprend en outre une structure rotationnelle disposée au niveau d'un côté de la deuxième plaque de support à l'écart de la première plaque de support, la structure rotationnelle comprend un arbre de rotation (223) et une tige de raccordement (224), la tige de raccordement est configurée pour raccorder l'arbre de rotation et la deuxième plaque de support l'un à l'autre de sorte que la deuxième plaque de support peut entraîner le mouvement de la tige de raccordement, et le mouvement de la tige de raccordement entraîne ensuite la rotation de l'arbre de rotation, et dans lequel un bord latéral de l'écran d'affichage flexible correspondant à la structure rotationnelle est fixé sur l'arbre de rotation, une extrémité de la tige de raccordement est raccordée à la deuxième plaque de support, et l'autre extrémité de la tige de raccordement est raccordée de manière amovible à l'arbre de rotation et peut tourner conjointement avec l'arbre de rotation.

2. Dispositif d'affichage selon la revendication 1, dans lequel une région de bord latéral de l'écran d'affichage flexible correspondant à la structure rotationnelle est disposée de manière déployée sur une surface périphérique externe de l'arbre de rotation.

3. Dispositif d'affichage selon la revendication 1, dans lequel une direction axiale de l'arbre de rotation est perpendiculaire à la direction d'extension du rail glissière.

4. Dispositif d'affichage selon la revendication 1, dans lequel la structure flexible comprend en outre une charnière pliable ou un arbre rotatif en métal.

5. Dispositif d'affichage selon l'une quelconque de la revendication 1, dans lequel la partie d'aide au pliage est configurée pour aider la partie de l'écran d'affichage flexible fixée de manière correspondante sur la deuxième plaque de support et la partie de l'écran d'affichage flexible fixée de manière correspondante sur la première plaque de support à former un angle variable de 180° à 360°, selon lequel un angle de 360° correspond à l'état dans lequel le dispositif d'affichage est plié, selon lequel un angle de 180° correspond à l'état dans lequel le dispositif d'affichage est déplié.

6. Dispositif d'affichage selon la revendication 5, comprenant en outre un capteur de position et un élément de contrôle, dans lequel le capteur de position et l'élément de contrôle sont raccordés électriquement ; le capteur de position est fourni sur l'arbre de rotation et configuré pour obtenir un angle de rotation de l'arbre de rotation ; l'élément de contrôle est configuré pour obtenir un angle de pliage ou de dépliage de l'écran d'affichage flexible en fonction de l'angle de rotation de l'arbre de rotation, et contrôler l'écran d'affichage flexible pour qu'il adopte différents modes d'affichage en fonction de l'angle de pliage ou de dépliage de l'écran d'affichage flexible.

7. Dispositif d'affichage selon la revendication 6, dans lequel,
lorsque l'angle de pliage ou de dépliage de l'écran d'affichage flexible est de 180°, l'écran d'affichage flexible est configuré pour adopter un mode d'affichage d'écran plat ;
lorsque l'angle de pliage ou de dépliage de l'écran d'affichage flexible change dans une plage de 180° à 225°, l'écran d'affichage flexible est configuré pour adopter un mode d'affichage de tournage de pages ; lorsque l'angle de pliage ou de dépliage de l'écran d'affichage flexible est de 270°, l'écran d'affichage flexible est configuré pour adopter un mode d'affichage de copie d'écran gauche et droite ;
lorsque l'angle de pliage ou de dépliage de l'écran d'affichage flexible change dans la plage de 270° à 360°, l'écran d'affichage flexible est configuré pour adopter un mode d'affichage d'économie d'énergie avec l'écran de gauche ou l'écran de droite éteint.
